# EUROPEAN PATENT APPLICATION

(11) **EP 4 170 429 A1**
(43) Date of publication of application: **26.04.2023**
(21) Application number: 21203532.3
(22) Date of filing: 19.10.2021
(51) Int. Cl.: G03F 7/20, G01N 21/956

(54) **OUT-OF-BAND LEAKAGE CORRECTION METHOD AND METROLOGY APPARATUS**

(71) Applicant: ASML Netherlands B.V., 5500 AH Veldhoven (NL)
(72) Inventor: KUZUCU, Oktay, Onur, 5500 AH Veldhoven (NL)
(74) Representative: ASML Netherlands B.V.

(57) **Abstract**

Disclosed is method of correcting a metrology image for an out-of-band leakage signal contribution resultant from leakage of measurement radiation at suppressed wavelengths. The method comprises: obtaining at least one correction image, said correction image obtained using measurement radiation with all wavelengths or wavelength bands maximally suppressed by a radiation modulation device; obtaining a metrology image using measurement radiation comprising modulated broadband radiation, modulated by the radiation modulation device to obtain a configured spectrum; and using the at least one correction image to correct the metrology image.

## Description

### BACKGROUND

### Field of the Invention

The present invention relates to methods and apparatus usable, for example, in the manufacture of devices by lithographic techniques, and to methods of manufacturing devices using lithographic techniques. The invention relates more particularly to metrology sensors and lithography apparatuses having such a metrology sensor.

### Background Art

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. These target portions are commonly referred to as "fields".

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down (by the same apparatus or a different lithographic apparatus) in previous layers. For this purpose, the substrate is provided with one or more sets of alignment marks. Each mark is a structure whose position can be measured at a later time using a position sensor, typically an optical position sensor. The lithographic apparatus includes one or more alignment sensors by which positions of marks on a substrate can be measured accurately. Different types of marks and different types of alignment sensors are known from different manufacturers and different products of the same manufacturer.

In other applications, metrology sensors are used for measuring exposed structures on a substrate (either in resist and/or after etch). A fast and non-invasive form of specialized inspection tool is a scatterometer in which a beam of radiation is directed onto a target on the surface of the substrate and properties of the scattered or reflected beam are measured. Examples of known scatterometers include angle-resolved scatterometers of the type described in US2006033921A1 and US2010201963A1. In addition to measurement of feature shapes by reconstruction, diffraction based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

It is often desirable to configure the spectrum of measurement radiation for a particular application applications. One method of doing this is to spatially modulate a spectrally dispersed beam. However, suppression of unwanted wavelengths or wavelength bands (i.e., those switched "off") using many otherwise suitable spatial modulation devices is below what is acceptable. It is desirable to improve measurement performance using measurement radiation having a spectrum configured in this way.

### SUMMARY OF THE INVENTION

The invention in a first aspect provides a method of correcting a metrology image for an out-of-band leakage signal contribution resultant from leakage of measurement radiation at suppressed wavelengths; the method comprising: obtaining at least one correction image, said correction image obtained using measurement radiation with all wavelengths or wavelength bands maximally suppressed by a radiation modulation device; obtaining a metrology image using measurement radiation comprising modulated broadband radiation, modulated by the radiation modulation device to obtain a configured spectrum; and using the at least one correction image to correct the metrology image.

Also disclosed is a metrology apparatus and a lithographic apparatus comprising a metrology device being operable to perform the method of the first aspect.

The above and other aspects of the invention will be understood from a consideration of the examples described below.

### BRIEF DESCRIPTION OF THE DRAWINGS

Embodiments of the invention will now be described, by way of example only, with reference to the accompanying drawings, in which:
Figure 1 depicts a lithographic apparatus;
Figure 2 illustrates schematically measurement and exposure processes in the apparatus of Figure 1;
Figure 3 is a schematic illustration of an alignment sensor adaptable according to an embodiment of the invention;
Figure 4 comprises (a) a schematic diagram of a dark field scatterometer for use in measuring targets using a first pair of illumination apertures, (b) a detail of diffraction spectrum of a target grating for a given direction of illumination;
Figure 5 is a schematic illustration of a grating light valve, illustrating its basic operation in (a) a top view, (b) an end-on view in a first configuration and (c) an end-on view in a second configuration;
Figure 6 is a schematic illustration of an illumination arrangement comprising a grating light valve; and
Figure 7 is a flowchart of a method for correcting a metrology image for an out-of-band leakage signal contribution resultant from leakage of measurement radiation at suppressed wavelengths according to an embodiment.

### DETAILED DESCRIPTION OF EMBODIMENTS

Before describing embodiments of the invention in detail, it is instructive to present an example environment in which embodiments of the present invention may be implemented.

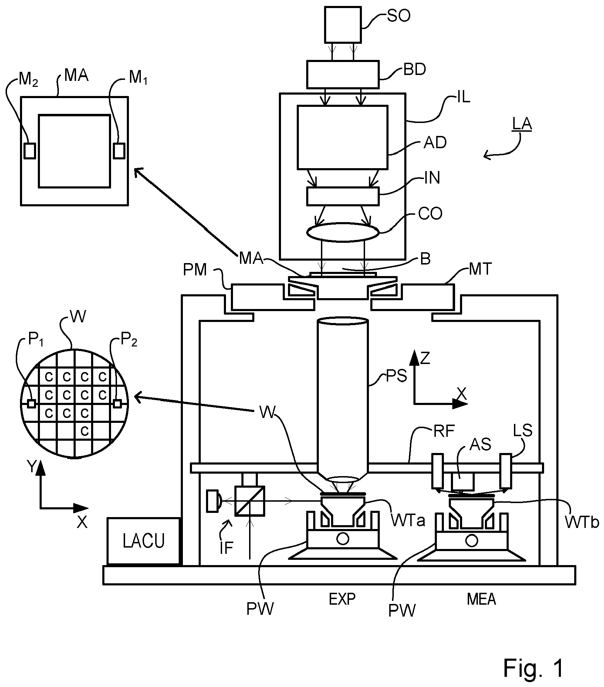

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation.

The patterning device support MT holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment marks may also be included within dies, in amongst the device features, in which case it is desirable that the markers be as small as possible and not require any different imaging or process conditions than adjacent features. The alignment system, which detects the alignment markers is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

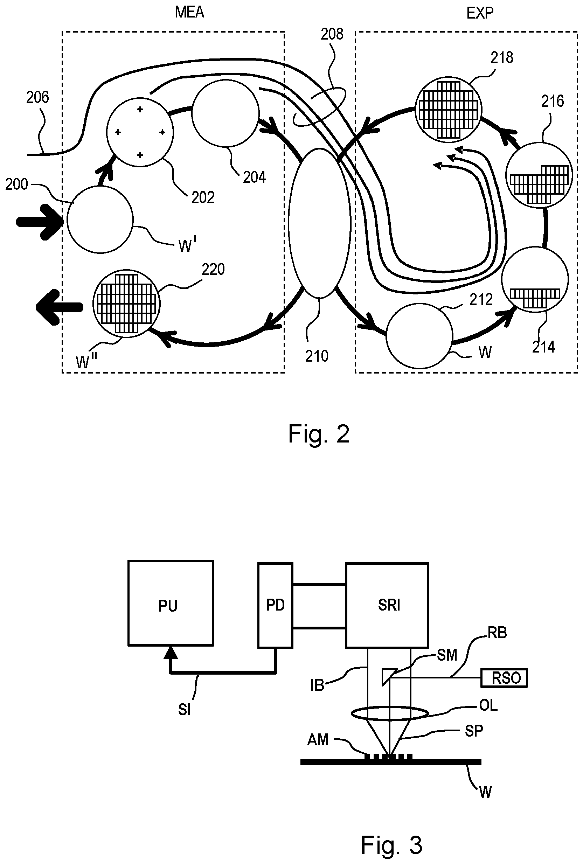

Figure 2 illustrates the steps to expose target portions (e.g. dies) on a substrate W in the dual stage apparatus of Figure 1. On the left hand side within a dotted box are steps performed at a measurement station MEA, while the right hand side shows steps performed at the exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus.

Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. These processing steps progressively introduce distortions in the substrate that must be measured and corrected for, to achieve satisfactory overlay performance.

The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

At 202, alignment measurements using the substrate marks PI etc. and image sensors (not shown) are used to measure and record alignment of the substrate relative to substrate table WTa/WTb. In addition, several alignment marks across the substrate W' will be measured using alignment sensor AS. These measurements are used in one embodiment to establish a "wafer grid", which maps very accurately the distribution of marks across the substrate, including any distortion relative to a nominal rectangular grid.

At step 204, a map of wafer height (Z) against X-Y position is measured also using the level sensor LS. Conventionally, the height map is used only to achieve accurate focusing of the exposed pattern. It may be used for other purposes in addition.

When substrate W' was loaded, recipe data 206 were received, defining the exposures to be performed, and also properties of the wafer and the patterns previously made and to be made upon it. To these recipe data are added the measurements of wafer position, wafer grid and height map that were made at 202, 204, so that a complete set of recipe and measurement data 208 can be passed to the exposure station EXP. The measurements of alignment data for example comprise X and Y positions of alignment targets formed in a fixed or nominally fixed relationship to the product patterns that are the product of the lithographic process. These alignment data, taken just before exposure, are used to generate an alignment model with parameters that fit the model to the data. These parameters and the alignment model will be used during the exposure operation to correct positions of patterns applied in the current lithographic step. The model in use interpolates positional deviations between the measured positions. A conventional alignment model might comprise four, five or six parameters, together defining translation, rotation and scaling of the 'ideal' grid, in different dimensions. Advanced models are known that use more parameters.

At 210, wafers W' and W are swapped, so that the measured substrate W' becomes the substrate W entering the exposure station EXP. In the example apparatus of Figure 1, this swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment marks M1, M2. In steps 214, 216, 218, scanning motions and radiation pulses are applied at successive target locations across the substrate W, in order to complete the exposure of a number of patterns.

By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 220, to undergo etching or other processes, in accordance with the exposed pattern.

The skilled person will know that the above description is a simplified overview of a number of very detailed steps involved in one example of a real manufacturing situation. For example rather than measuring alignment in a single pass, often there will be separate phases of coarse and fine measurement, using the same or different marks. The coarse and/or fine alignment measurement steps can be performed before or after the height measurement, or interleaved.

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down in previous layers (by the same apparatus or a different lithographic apparatus). For this purpose, the substrate is provided with one or more sets of marks. Each mark is a structure whose position can be measured at a later time using a position sensor, typically an optical position sensor. The position sensor may be referred to as "alignment sensor" and marks may be referred to as "alignment marks".

A lithographic apparatus may include one or more (e.g. a plurality of) alignment sensors by which positions of alignment marks provided on a substrate can be measured accurately. Alignment (or position) sensors may use optical phenomena such as diffraction and interference to obtain position information from alignment marks formed on the substrate. An example of an alignment sensor used in current lithographic apparatus is based on a self-referencing interferometer as described in US6961116. Various enhancements and modifications of the position sensor have been developed, for example as disclosed in US2015261097A1. The contents of all of these publications are incorporated herein by reference.

A mark, or alignment mark, may comprise a series of bars formed on or in a layer provided on the substrate or formed (directly) in the substrate. The bars may be regularly spaced and act as grating lines so that the mark can be regarded as a diffraction grating with a well-known spatial period (pitch). Depending on the orientation of these grating lines, a mark may be designed to allow measurement of a position along the X axis, or along the Y axis (which is oriented substantially perpendicular to the X axis). A mark comprising bars that are arranged at +45 degrees and/or -45 degrees with respect to both the X- and Y-axes allows for a combined X- and Y- measurement using techniques as described in US2009/195768A, which is incorporated by reference.

The alignment sensor scans each mark optically with a spot of radiation to obtain a periodically varying signal, such as a sine wave. The phase of this signal is analyzed, to determine the position of the mark and, hence, of the substrate relative to the alignment sensor, which, in turn, is fixated relative to a reference frame of a lithographic apparatus. So-called coarse and fine marks may be provided, related to different (coarse and fine) mark dimensions, so that the alignment sensor can distinguish between different cycles of the periodic signal, as well as the exact position (phase) within a cycle. Marks of different pitches may also be used for this purpose.

Measuring the position of the marks may also provide information on a deformation of the substrate on which the marks are provided, for example in the form of a wafer grid. Deformation of the substrate may occur by, for example, electrostatic clamping of the substrate to the substrate table and/or heating of the substrate when the substrate is exposed to radiation.

Figure 3 is a schematic block diagram of an embodiment of a known alignment sensor AS. Radiation source RSO provides a beam RB of radiation of one or more wavelengths, which is diverted by diverting optics onto a mark, such as mark AM located on substrate W, as an illumination spot SP. In this example the diverting optics comprises a spot mirror SM and an objective lens OL. The illumination spot SP, by which the mark AM is illuminated, may be slightly smaller in diameter than the width of the mark itself.

Radiation diffracted by the mark AM is collimated (in this example via the objective lens OL) into an information-carrying beam IB. The term "diffracted" is intended to include zero-order diffraction from the mark (which may be referred to as reflection). A self-referencing interferometer SRI, e.g. of the type disclosed in US6961116 mentioned above, interferes the beam IB with itself after which the beam is received by a photodetector PD. Additional optics (not shown) may be included to provide separate beams in case more than one wavelength is created by the radiation source RSO. The photodetector may be a single element, or it may comprise a number of pixels, if desired. The photodetector may comprise a sensor array.

The diverting optics, which in this example comprises the spot mirror SM, may also serve to block zero order radiation reflected from the mark, so that the information-carrying beam IB comprises only higher order diffracted radiation from the mark AM (this is not essential to the measurement, but improves signal to noise ratios).

Intensity signals SI are supplied to a processing unit PU. By a combination of optical processing in the block SRI and computational processing in the unit PU, values for X- and Y-position on the substrate relative to a reference frame are output.

A single measurement of the type illustrated only fixes the position of the mark within a certain range corresponding to one pitch of the mark. Coarser measurement techniques are used in conjunction with this to identify which period of a sine wave is the one containing the marked position. The same process at coarser and/or finer levels are repeated at different wavelengths for increased accuracy and/or for robust detection of the mark irrespective of the materials from which the mark is made, and materials on and/or below which the mark is provided. Improvements in performing and processing such multiple wavelength measurements are disclosed below.

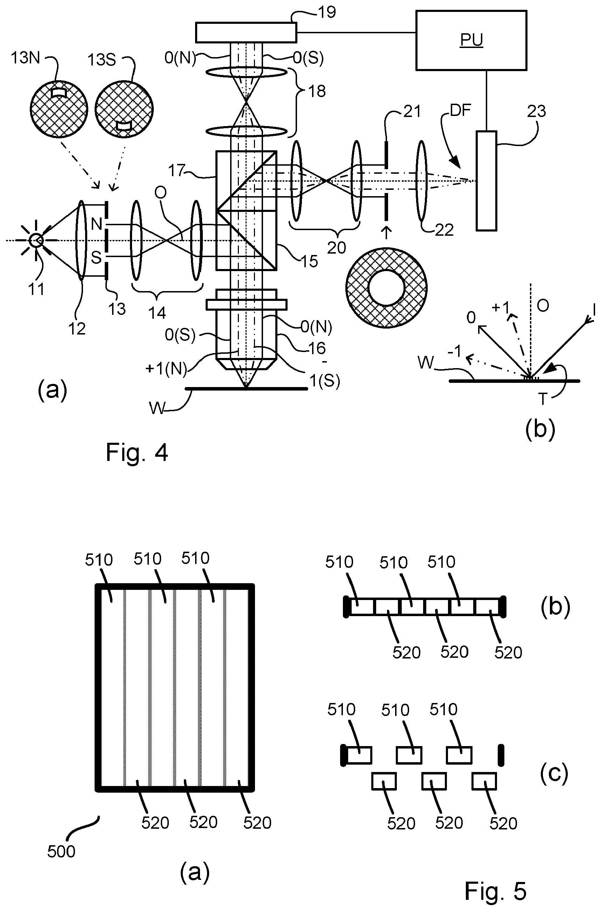

A metrology apparatus is shown in Figure 4(a). A target T and diffracted rays of measurement radiation used to illuminate the target are illustrated in more detail in Figure 4(b). The metrology apparatus illustrated is of a type known as a dark field metrology apparatus. The metrology apparatus depicted here is purely exemplary, to provide an explanation of dark field metrology. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 4(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 4(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 4(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 4 are purely examples. In another embodiment of the invention, on-axis illumination of the targets is used and an aperture stop with an off-axis aperture is used to pass substantially only one first order of diffracted light to the sensor. In other examples, a two quadrant aperture may be used. This may enable simultaneous detection of plus and minus orders, as described in US2010201963A1, mentioned above. Embodiments with optical wedges (segmented prisms or other suitable elements) in the detection branch can be used to separate the orders for imaging spatially in a single image, as described in US2011102753A1, mentioned above. In yet other embodiments, 2nd, 3rd and higher order beams (not shown in Figure 4) can be used in measurements, instead of or in addition to the first order beams. In yet other embodiments, a segmented prism can be used in place of aperture stop 21, enabling both +1 and -1 orders to be captured simultaneously at spatially separate locations on image sensor 23.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented.

A light source for metrology applications usable for concepts disclosed herein may be based on a hollow core fiber such as a hollow core photonic crystal fiber (HC-PCF). The hollow core of the fiber may be filled with a gas acting as a broadening medium for broadening input radiation. Such a fiber and gas arrangement may be used to create a supercontinuum radiation source. Radiation input to the fiber may be electromagnetic radiation, for example radiation in one or more of the infrared, visible, UV, and extreme UV spectra. The output radiation may consist of or comprise broadband radiation, which may be referred to herein as white light. This is only one example of a broadband light source technology usable in methods and apparatuses disclosed herein, and other suitable technologies may instead be employed.

Metrology sensors include those designed predominately for pre-exposure metrology or alignment, such as the alignment sensor illustrated in Figure 3, and those designed predominately for post-exposure metrology (e.g., overlay, CD and/or focus monitoring) such as the metrology apparatus illustrated in Figure 4. In either case, it is often desirable to control the illumination spectrum, e.g., to switch the illumination between different wavelengths (colors) and/or wavefront profiles.

Typically, color selection may be implemented using a color filter arrangement (e.g., one or more color wheels which rotate different color filters into the beam path as required) or a linear variable filter arrangement. These color filter based arrangements provide acceptable to excellent suppression of the blocked colors, e.g., a suppression performance on the order of OD4 or better (<10⁻⁴ attenuation for unwanted wavelengths where OD is Optical Density). However, the switching filter arrangements can be slower than desired, and they offer little or no flexibility in many aspects of control of the illumination spectrum, such as providing for tunable transmission of a color band, tunable bandwidth of a color band and/or switching of multiple color bands simultaneously on/off.

Therefore, to provide faster switching speeds and/or better spectrum characteristic control, color selection may be implemented via radiation modulation devices such as a spatial light modulation device (SLM), e.g., a Digital Micromirror Device (DMD)/Grating Light Valve (GLV) module. Such modulation devices may be used to spatially modulate a spectrally dispersed broadband beam of source radiation. For such devices, the degree of unwanted wavelength suppression depends on the performance of the active device (modulation device), which modulates the amplitude of spectral intensity of the light source.

By way of a specific example, a source selection module may use a grating light valve (GLV) technology such as marketed by Silicon Light Machines. A GLV is a Micro-Electro-Mechanical Systems (MEMS) technology. Figure 5 illustrates the principle. Figure 5 is a schematic illustration of a GLV pixel or component 500 from (a) above and (b), (c) end-on. The GLV component comprises alternating GLV reflective ribbons of two types: static or bias ribbons 510 which are typically grounded along with a common electrode and driven or active ribbons 520 which are driven by an electronic driver channel. A GLV module may comprise any number of these GLV components 500 arranged in an array. The active and bias ribbons may be essentially identical other than in how they are driven. When no voltage is applied to the active ribbons 520, they are co-planar with the bias ribbons, a configuration illustrated in Figure 5(b). In this configuration, the GLV acts essentially as a mirror, with incident light being specularly reflected. When a voltage is applied to the active ribbons 520, as illustrated in Figure 5(c), they deflect relative to the bias ribbons 510, establishing a square-well diffraction grating. In this state, incident light is diffracted into fixed diffraction angles. The ratio of light reflected with respect to light diffracted can be continuously varied by controlling the voltage on the active ribbons 520, which controls the magnitude of their deflection. As such, the amount of light diffracted by the GLV can be controlled in an analog fashion from zero (full specular reflection) to all incident light (zero specular reflection). It should be noted that this is only one implementation of a GLV and other implementations are possible and can be used in the concepts disclosed herein. For example, one set of ribbons may be fixed onto the substrate, with the other set of ribbons being movable.

Such a GLV module may provide tunable transmission per color band and therefore allow for better spectrum shaping and control. The GLV module may be used in a zeroth order mode such that the diffracted radiation is blocked/dumped and the zeroth order radiation is provided to the metrology tool. This has the advantage of preserving etendue.

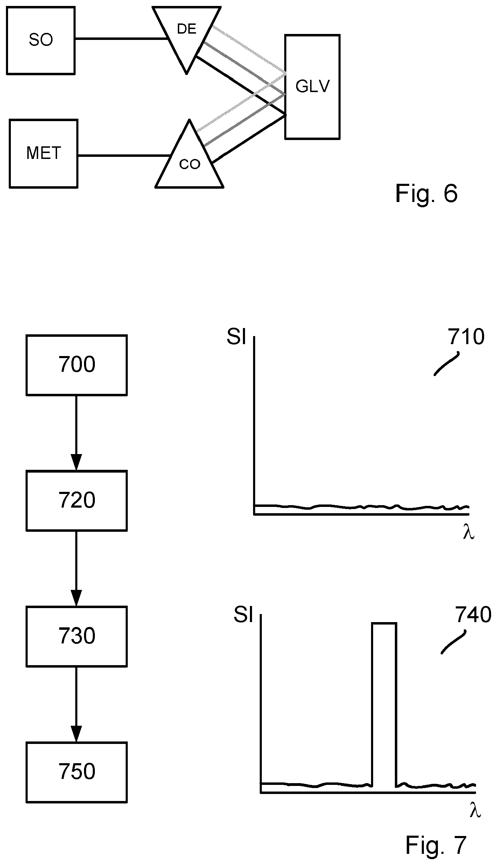

Figure 6 is a schematic illustration of such a GLV-based source selection module. A broadband or multiple color radiation source SO provides broadband or multiple color radiation. A dispersion element DE (which may be any suitable beam dispersion element e.g., a prism or grating) is used to disperse the broadband radiation. A grating light valve module GLV is used to modulate the spectrum of the dispersed radiation. The modulated radiation is then recombined using beam combiner CO (which may be any suitable beam combining element e.g., a prism or grating). The combined beam can then be used by a metrology tool MET as source illumination.

Light modulation techniques which rely on active switching elements can have a poorer unwanted wavelength suppression performance compared to color filtering based methods. For GLV-based filtering methods, for example, this performance can be OD2-OD2.5. This gives rise to unwanted signals being detected on the application side (detector side of the target) which can impact the matching, accuracy and robustness performance of the metrology tool. It is very difficult to improve this suppression performance via improvements in the hardware, without significantly complicating the design and increasing the total system cost.

As such, a calibration-based method is proposed for addressing the insufficient wavelength suppression issue, which calibrates for an out-of-band leakage signal contribution (leakage of unselected wavelengths onto the sample, e.g., substrate/target, and then onto the detector).

In the proposed method, the out-of-band leakage signal contribution may be treated in a similar manner to other unwanted signal artifacts, such as camera dark current noise. However, in this case the out-of-band leakage signal contribution is modulated through target response, and therefore varies with spectral reflectance of the target or sample/target asymmetry, if present. As such, where the target is an overlay or focus target, this out-of-band leakage signal contribution will vary with the actual overlay or focus parameter being measured. In an alignment setting, the out-of-band leakage signal contribution will vary with any alignment mark asymmetry present.

Because of this, a correction determined by such a calibration may be applied at/after the detection plane (i.e., where the image is captured), and not at the modulation location (e.g., not in the illumination branch). The calibration may be performed only once, performed per target, or performed for a representative sample (proper subset) of the targets (e.g., representative of an expected variation of the target of interest).

Figure 7 is a flowchart of a first method according to the concepts disclosed herein. Such a method may comprise an inline or offline calibration, and may be appropriate when the target response to the out-of-band leakage signal contribution is low (i.e., there is low or negligible crosstalk between the leakage signal and the parameter of interest response of the target). Such a method may then comprise a calibration based on measurement of only one or a few targets from a wafer.

At step 700, a measurement acquisition from each of one or a few targets may be obtained with the modulation element (e.g., SLM/GLV) set at its maximum suppression over the full wavelength range of the source illumination (e.g., all colors are switched off). The output spectrum 710 of the modulated (suppressed) illumination branch is shown, showing the source intensity SI against wavelength λ. The resulting image (or a combination, e.g., an average, of images from more than one target) may be stored as a correction image (step 720). At step 730 a metrology image is acquired of a target (e.g., in a manufacturing setting), with a desired illumination setting for the target such as illustrated by output spectrum 740 (e.g., a normal acquisition setting). Of course, this is purely an example output spectrum; the modulation and therefore the output spectrum will be application appropriate, e.g., as determined in a measurement recipe setup stage for the target/stack. At step 750, the correction image obtained at step 720 may be used to correct the metrology image obtained at step 730. For example, the correction image may be used as an offset correction for the metrology image obtained at step 730. (i.e., the correction image may be subtracted from the metrology image). Steps 730 to 750 can then be repeated for all targets on the wafer (or lot/group of wafers).

Optionally the correction image and/or metrology image may first be processed before being used to correct the metrology image (e.g., prior to step 750). Such processing may comprise scaling the correction image and/or metrology image according to any dose (i.e., a measure of the number of photons or total power of the measurement radiation used for the measurement) or integration time variations. Each image will have an associated dose and integration time, which may change over time- e.g., dose may be changed per measurement to maintain integration time constant (or *vice versa)* if source brightness decreases over time. The scaling of the correction image and/or metrology image may compensate for changes in integration time and/or dose between image captures such that the images are scaled to have the same effective integration time and/or dose.

Such a calibration may be performed offline, e.g., where the out-of-band leakage signal contribution is not expected to vary much over time. Such an offline calibration may be performed on a similar target and stack as the target and stack measurements which are to be corrected by the calibration output (the correction image(s)). As such, the calibration may be application dependent. Alternatively, or in addition, the calibration may comprise an inline calibration during a manufacturing phase. For example, calibrations may be repeated periodically to obtain updated correction images, to compensate or mitigate for drifts or variation over time of the out-of-band leakage signal contribution.

In situations where the leakage signal-parameter of interest crosstalk is expected to be non-negligible, such a correction image may be acquired on a per-target basis. Such a method may comprise performing two acquisitions of each target in the manufacturing phase (e.g., there may be no initial correction image captured in a calibration phase): a first acquisition with all colors switched off (maximum suppression) such as illustrated by the output spectrum 710, and the second acquisition with the desired illumination setting for that target. This approach provides the greatest correction accuracy, but at a cost in throughput due to double acquisition of images for all targets. This double acquisition approach may be performed for all wafers of a lot, or a proper subset of wafers of a lot, for example.

A more balanced approach may comprise measuring only a proper subset of the targets on each wafer or each lot using the aforementioned double acquisition method, and characterizing the crosstalk, e.g., determining a relationship between an (e.g., intensity) parameter of the metrology image and the out-of-band leakage signal contribution. This relationship can then be used to determine which correction image should be used to correct a particular metrology image captured in a single acquisition and/or determine a scaling for a correction image to mitigate the crosstalk. The proper subset may comprise fewer than 25%, fewer than 20%, fewer than 15% or fewer than 10% of the targets on the wafer. The proper subset may comprise more than 1%, more than 3%, more than 5% or more than 8% of the targets on the wafer. The proportion of targets measured may be fixed (e.g., predetermined) or variable over a lot, for example based on an assessment of the crosstalk impact determined from measurements so far.

This approach assumes that the double-acquired proper subset of targets comprises a population which (e.g., sufficiently) covers the parameter of interest variability expected (e.g., over the wafer and/or lot). As such, the proper subset may be well distributed over a wafer and/or lot.

In an embodiment, once the relationship between the parameter of the metrology image and the out-of-band leakage signal contribution is established, it is possible to determine and apply an appropriately scaled version of the correction image (captured at maximum wavelength suppression), depending on the value of the parameter of the metrology image detected per metrology image. This approach saves some throughput performance at the expense of accuracy performance compared to the full double acquisition method.

The parameter of the acquisition image may comprise an intensity parameter of the metrology image, for example an intensity parameter not dependent (or having a low dependence) on the parameter of interest. There are many options for this intensity parameter, which may depend on the metrology method being employed. For example, a micro-diffraction based overlay (µDBO) or diffraction based focus (DBF) image may comprise one or more (typically four for µDBO) regions of interest, each corresponding to a main grating area of a respective sub-target or pad. Outside of these regions of interest may comprise edge regions (which often appear higher intensity than the regions of interest in the image). In such an embodiment, the intensity parameter of the metrology image may comprise the intensity of these edge regions. Alternatively, or in addition, the intensity parameter of the metrology image may comprise the intensity of any other part of the acquired metrology image outside of the regions of interest used to determine the main parameter of interest signal.

In some embodiments, the images may be pupil images, for example when using in-device metrology (IDM) techniques. In IDM, a wafer is measured (e.g., after-etch) using, for example, a metrology tool such as illustrated in Figure 4(a) (using the pupil imaging branch). The resulting optical signals, typically referred to as "pupils", each comprise an angularly resolved spectrum of measured values or signal parameter values (e.g., intensities, diffraction efficiencies or any other suitable parameter). These pupils are obtained from radiation scattered from a "target" on the substrate, and may comprise radiation from any one or more diffraction orders, where a diffraction order in this context includes the zeroth order (specularly reflected radiation). As such, a pupil may be obtained from only the zeroth order, only a single higher order or a combination of orders. The measured pupil may then be mapped to a value for the parameter of interest, e.g., using a trained model.

Such pupil images (regardless of the metrology method used) also comprise regions at the periphery of the pupil which carry little or no parameter of interest information, and as such one or more measured intensities in this peripheral region may be used as the intensity parameter of the metrology image.

In other pupil-based embodiments, a "dual pupil" method is known, where a weighting is determined from a co-polarized pupil obtained from wafer/target/stack, and then applied to a corresponding cross-polarized pupil, the weighting being optimized to compensate for symmetric process effects such that, where each target has the same overlay but subject to different process effects, the inferred overlay will be (at least approximately) the same. In such an approach, the measurement radiation may be polarized and a cross-polarizer used on the scattered radiation to divide the scattered radiation into two measurement channels, a cross-polarized channel (which provides cross-polarized pupils) where the polarization state of the illumination beam differs from the detection branch polarization state and a co-polarized channel (which provides co-polarized pupils) where the polarization state of the illumination beam matches the detection branch polarization state. The co-polarized pupils do not carry the parameter of interest signal (assuming the parameter of interest is asymmetry based, such as overlay or DBF focus), and therefore the intensity or intensity pattern of these co-polarized pupils may be used as the intensity parameter of the metrology image.

Instead of or in addition to determining this relationship based on inline measurement of a subset of the actual metrology targets, the relationship between the parameter of the metrology image and the out-of-band leakage signal contribution may be determined in an initial calibration phase. In such an embodiment, this relationship may be determined on one or more calibration wafers (or standard wafers) comprising a plurality of calibration targets over which the parameter of interest is deliberately varied. In IDM metrology for inferring overlay, an array of suitable targets with overlay varying between targets, is already used for training of the pupil inference (inferring overlay from the pupil measurement). These targets may be used as calibration targets in such an embodiment.

In an embodiment a suitable model, such as a machine learning model (e.g., a neural network) may be trained to determine the scaling of the correction image based on the parameter of the metrology image, or simply the metrology image. Such a model may be trained on data from calibration targets as described or actual targets with sufficient parameter of interest variation.

Further embodiments of the method, metrology device and lithographic apparatus are disclosed in the subsequent list of numbered clauses:
1. A method of correcting a metrology image for an out-of-band leakage signal contribution resultant from leakage of measurement radiation at suppressed wavelengths; the method comprising:
   obtaining at least one correction image, said correction image obtained using measurement radiation with all wavelengths or wavelength bands maximally suppressed by a radiation modulation device;
   obtaining a metrology image using measurement radiation comprising modulated broadband radiation, modulated by the radiation modulation device to obtain a configured spectrum; and
   using the at least one correction image to correct the metrology image.
2. A method as defined in clause 1, wherein said correction image and said metrology image each comprise an image of the same structure or similar structures.
3. A method as defined in clause 1 or 2, wherein said correction step is performed at or after a detection plane where said metrology image is detected.
4. A method as defined in any preceding clause, comprising measuring at least one calibration structure with all wavelengths or wavelength bands maximally suppressed in a calibration phase to obtain said correction image; and
   using said correction image to correct one or more metrology images measured in a manufacturing phase.
5. A method as defined in clause 4, wherein said one or more metrology images each comprise images of a similar structure to said at least one calibration structure.
6. A method as defined in any preceding clause, comprising periodically measuring a structure with all wavelengths maximally suppressed in a production phase to obtain an updated correction image; and
   using the updated correction image for correction of subsequent metrology images.
7. A method as defined in clause 1, 2 or 3, comprising measuring the same structure in a first acquisition and a second acquisition to obtain said correction image and metrology image respectively.
8. A method as defined in clause 7, comprising performing said first acquisition and said second acquisition for each structure measured in a manufacturing phase.
9. A method as defined in clause 8, comprising performing said first acquisition and said second acquisition for a proper subset of the structures to be measured; and
   using the correction images and metrology images obtained in said first acquisitions and said second acquisitions to scale a correction image for a particular structure measured in a subsequent metrology image and/or select a correction image obtained in said first acquisitions appropriate for a particular structure measured in a subsequent metrology image.
10. A method as defined in clause 9, wherein said proper subset of structures comprise an expected variation in a parameter of interest.
11. A method as defined in clause 9 or 10, comprising determining a relationship between a parameter of the metrology image and the out-of-band leakage signal contribution; and
   using said relationship to determine the scaling and/or to select said correction image appropriate for a particular structure.
12. A method as defined in clause 9 or 10, comprising training a model to map said parameter of the metrology image to the scaling for the correction image.
13. A method as defined in clause 11 or 12, comprising determining said relationship or training said model in an initial calibration phase.
14. A method as defined in clause 13, comprising determining said relationship or training said model using calibration structures over which a parameter of interest is deliberately varied.
15. A method as defined in any of clauses 9 to 14, comprising measuring a structure in a production phase to obtain said subsequent metrology image; and
   using said scaling to scale said correction image to correct said subsequent metrology image.
16. A method as defined in any of clauses 9 to 15, wherein said parameter of the metrology image comprises an intensity parameter of the metrology image.
17. A method as defined in any of clauses 9 to 16, wherein said parameter of the metrology image comprises a parameter which has minimal dependence on a parameter of interest.
18. A method as defined in clause 16 or 17, wherein said parameter of the metrology image comprises an intensity value of one or more portions of the metrology image outside a region of interest from which the parameter of interest is inferred.
19. A method as defined in clause 16 or 17, wherein said parameter of the metrology image comprises one or more intensity values from a co-polarized pupil image.
20. A method as defined in any preceding clause, wherein said configured spectrum comprises a spectrum configured for measurement of said structure, as determined in a spectrum configuration step.
21. A method as defined in any preceding clause, wherein said radiation modulation device comprises a spatial light modulation device, a digital micromirror device or a grating light valve module operable to spatially modulate a spectrally dispersed beam of said measurement radiation.
22. A method as defined in any preceding clause, comprising using the corrected image to determine a parameter of interest.
23. A method as defined in clause 22, wherein the parameter of interest is one of overlay, focus or a position value.
24. A method as defined in any preceding clause, comprise scaling the correction image and/or metrology image to mitigate any dose or integration time variations between said correction image and metrology image.
25. A method as defined in any preceding clause, wherein said correction step comprises subtracting the correction image from the metrology image.
26. A metrology device operable to perform the method of any preceding clause.
27. A metrology device as defined in clause 26, comprising a source module, the source module comprising:
   a radiation source for generating a broadband illumination beam;
   a beam dispersing element for dispersing the broadband illumination beam;
   a spatial modulation device for spatially modulating the broadband illumination beam subsequent to being dispersed; and
   a beam combining element to recombine the spatially modulated broadband illumination beam to obtain an output source beam.
28. A metrology device as defined in clause 27, wherein said spatial modulation device comprises one of a grating light valve module or a digital micromirror device.
29. A metrology device as defined in any of clauses 26 to 28, wherein the metrology device comprises a scatterometer.
30. A metrology device as defined in clause 29, comprising:
   a support for a substrate;
   an optical system for directing said measurement radiation to a structure on said substrate; and
   a detector for detecting the measurement radiation scattered by the structure on the substrate.
31. A metrology device as defined in any of clauses 26 to 28, wherein the metrology device comprises an alignment sensor.
32. A lithographic apparatus comprising:
   a patterning device support for supporting a patterning device;
   a substrate support for supporting a substrate; and
   the metrology device of clause 31 being operable to perform alignment of said patterning device and/or said substrate support.

While the concepts disclosed herein have been disclosed mainly in the context of post-exposure metrology, the concepts may equally applied to pre-exposure metrology such as alignment or any metrology methods where the measurement radiation is modulated by a modulation device such as an SLM or GLV device.

The concepts herein reduce the leakage impact in inherent in modulation devices such as a SLM or GLV device without requiring costly hardware redesign, and without loss of photons. The correction may be an online and/or offline correction in the detection branch.

It should be appreciated that the term color is used throughout this text synonymously with wavelength or spectral component and the colors may include those outside the visible band (e.g., infrared or ultraviolet wavelengths).

While specific embodiments of the invention have been described above, it will be appreciated that the invention may be practiced otherwise than as described.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 1-100 nm), as well as particle beams, such as ion beams or electron beams.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

The breadth and scope of the present invention should not be limited by any of the above-described exemplary embodiments, but should be defined only in accordance with the following claims and their equivalents.

## Claims

1. A method of correcting a metrology image for an out-of-band leakage signal contribution resultant from leakage of measurement radiation at suppressed wavelengths; the method comprising:
obtaining at least one correction image, said correction image obtained using measurement radiation with all wavelengths or wavelength bands maximally suppressed by a radiation modulation device;
obtaining a metrology image using measurement radiation comprising modulated broadband radiation, modulated by the radiation modulation device to obtain a configured spectrum; and
using the at least one correction image to correct the metrology image.

2. A method as claimed in claim 1, wherein said correction image and said metrology image each comprise an image of the same structure or similar structures.

3. A method as claimed in claim 1 or 2, wherein said correction step is performed at or after a detection plane where said metrology image is detected.

4. A method as claimed in any preceding claim, comprising measuring at least one calibration structure with all wavelengths or wavelength bands maximally suppressed in a calibration phase to obtain said correction image; and
using said correction image to correct one or more metrology images measured in a manufacturing phase.

5. A method as claimed in claim 1, 2 or 3, comprising measuring the same structure in a first acquisition and a second acquisition to obtain said correction image and metrology image respectively.

6. A method as claimed in claim 5, comprising performing said first acquisition and said second acquisition for a subset of the structures to be measured; and
using the correction images and metrology images obtained in said first acquisitions and said second acquisitions to scale a correction image for a particular structure measured in a subsequent metrology image and/or select a correction image obtained in said first acquisitions appropriate for a particular structure measured in a subsequent metrology image.

7. A method as claimed in claim 6, comprising determining a relationship between a parameter of the metrology image and the out-of-band leakage signal contribution; and
using said relationship to determine the scaling and/or to select said correction image appropriate for a particular structure.

8. A method as claimed in claim 6 or 7, wherein said parameter of the metrology image comprises an intensity parameter of the metrology image.

9. A method as claimed in any preceding claim, wherein said radiation modulation device comprises a spatial light modulation device, a digital micromirror device or a grating light valve module operable to spatially modulate a spectrally dispersed beam of said measurement radiation.

10. A method as claimed in any preceding claim, comprising using the corrected image to determine a parameter of interest.

11. A method as claimed in claim 10, wherein the parameter of interest is one of overlay, focus or a position value.

12. A method as claimed in any preceding claim, comprise scaling the correction image and/or metrology image to mitigate any dose or integration time variations between said correction image and metrology image.

13. A method as claimed in any preceding claim, wherein said correction step comprises subtracting the correction image from the metrology image.

14. A metrology device operable to perform the method of any preceding claim.

15. A metrology device as claimed in claim 14, comprising a source module, the source module comprising:
a radiation source for generating a broadband illumination beam;
a beam dispersing element for dispersing the broadband illumination beam;
a spatial modulation device for spatially modulating the broadband illumination beam subsequent to being dispersed; and
a beam combining element to recombine the spatially modulated broadband illumination beam to obtain an output source beam.
